# EUROPEAN PATENT APPLICATION

(11) **EP 4 779 339 A1**
(43) Date of publication of application: **22.07.2026**
(21) Application number: 25847672.0
(22) Date of filing: 25.03.2025
(51) Int. Cl.: G01R 31/392, G01R 31/367, G01R 31/382, G01R 31/389, H02J 7/00

(54) **BATTERY CONTROL DEVICE AND VEHICLE CONTROL DEVICE**

(30) Priority: 31.07.2024 JP 2024124118
(71) Applicant: Vehicle Energy Japan Inc., Hitachinaka-shi, Ibaraki 312-8505 (JP)
(72) Inventor: IMAI Shinji, Hitachinaka-shi, Ibaraki 312-8505 (JP)
(74) Representative: Mewburn Ellis LLP
(86) International application number: PCT/JP2025/011635
(87) International publication number: WO 2026/028517

(57) **Abstract**

A calculation device 130 of a battery control apparatus calculates a first resistance value R1 of a secondary battery based on the amount of change in a voltage value during a time from a first time-point c1 to a second time-point c2 and the amount of change in a current value during the time from the first time-point to the second time-point. Next, the calculation device 130 calculates an amount of change β in a surface temperature based on a first surface temperature Ts1 within a range from the first time-point to the second time-point and a second surface temperature Ts2 at a third time-point at which a predetermined time n has elapsed from the second time-point. Next, the calculation device 130 calculates the amount of current of the secondary battery from a time point at which the first surface temperature has been measured to the third time-point c3 at which the second surface temperature has been measured. Next, the calculation device 130 estimates an internal temperature of the secondary battery based on the amount of change in the surface temperature and the amount of current. Next, the calculation device 130 estimates a second resistance value R2 that reflects a difference between the internal temperature and the surface temperature of the secondary battery, based on the estimated internal temperature with reference to a map. The calculation device 130 calculates a deterioration rate based on the first and the second resistance values.

## Description

### Technical Field

The present invention relates to a battery control apparatus and a vehicle control apparatus.

### Background Art

Conventionally, a technique for determining deterioration of a secondary battery has been known (refer to Patent Document 1).

### Prior Art Document

### Patent Document

Patent Document 1: JP-2016-215836-A

### Summary of the Invention

### Problem to be Solved by the Invention

In battery control and vehicle control, improvement in calculation accuracy of a deterioration rate of a secondary battery is required.

### Means for Solving the Problem

A battery control apparatus according to an aspect of the present invention includes a map in which data indicating a relation between a surface temperature, an internal temperature, and a resistance value of a secondary battery is included and a calculation device configured to calculate a deterioration rate of the secondary battery based on an amount of change in each of a voltage value, a current value, and the surface temperature of the secondary battery. The calculation device is configured to calculate a first resistance value of the secondary battery based on an amount of change in the voltage value during a time from a first time-point to a second time-point and an amount of change in the current value during the time from the first time-point to the second time-point. The calculation device is configured to calculate an amount of change in the surface temperature based on a first surface temperature within a range from the first time-point to the second time-point and a second surface temperature at a third time-point at which a predetermined time has elapsed from the second time-point. The calculation device is configured to calculate an amount of current of the secondary battery from a time point at which the first surface temperature has been measured to the third time-point at which the second surface temperature has been measured. The calculation device is configured to estimate the internal temperature of the secondary battery based on the amount of change in the surface temperature and the amount of current. The calculation device is configured to estimate a second resistance value that reflects a difference between the internal temperature and the surface temperature of the secondary battery, based on the estimated internal temperature, while referring to the relation between the surface temperature, the internal temperature, and the resistance value stored in the map. The calculation device is configured to calculate the deterioration rate based on the first resistance value and the second resistance value.

A vehicle control apparatus according to an aspect of the present invention is a vehicle control apparatus including the battery control apparatus. The vehicle control apparatus is configured to control a vehicle having the secondary battery and electric equipment actuated by electric power of the secondary battery.

### Advantage of the Invention

According to the present invention, in battery control and vehicle control, calculation accuracy of the deterioration rate of the secondary battery can be improved.

### Brief Description of the Drawings

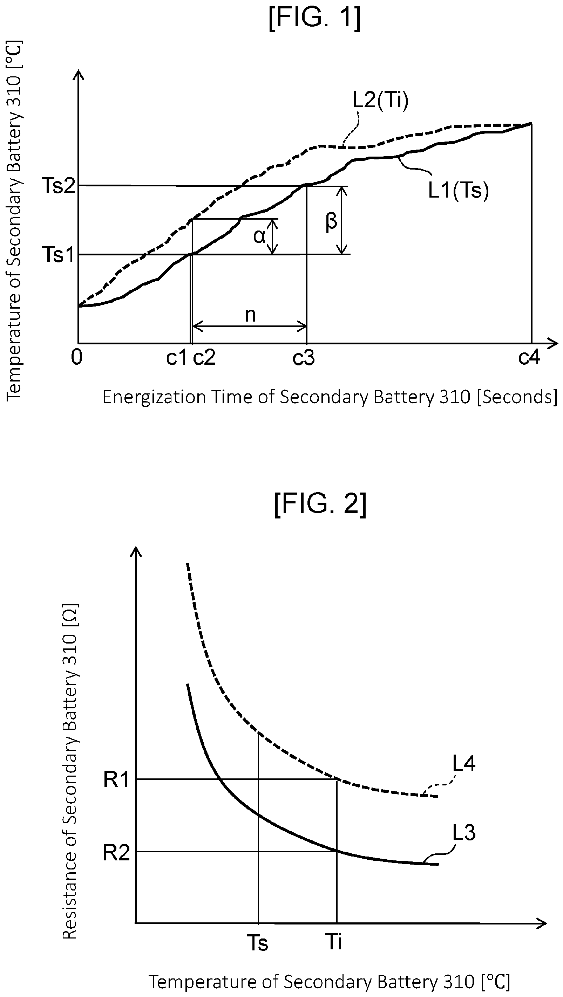

[Fig. 1] Fig. 1 is a graph depicting temperature characteristics of a secondary battery 310, and is a graph depicting, in an overlapping manner, an example of a relation between an energization time and an internal temperature Ti of the secondary battery 310 and a relation between the energization time and a surface temperature Ts of the secondary battery 310.
[Fig. 2] Fig. 2 is a graph depicting temperature characteristics of the secondary battery 310, and is a graph depicting, in an overlapping manner, an example of a relation between a temperature T and resistance of the secondary battery 310 before deterioration and a relation between the temperature T and the resistance of the secondary battery 310 after deterioration.

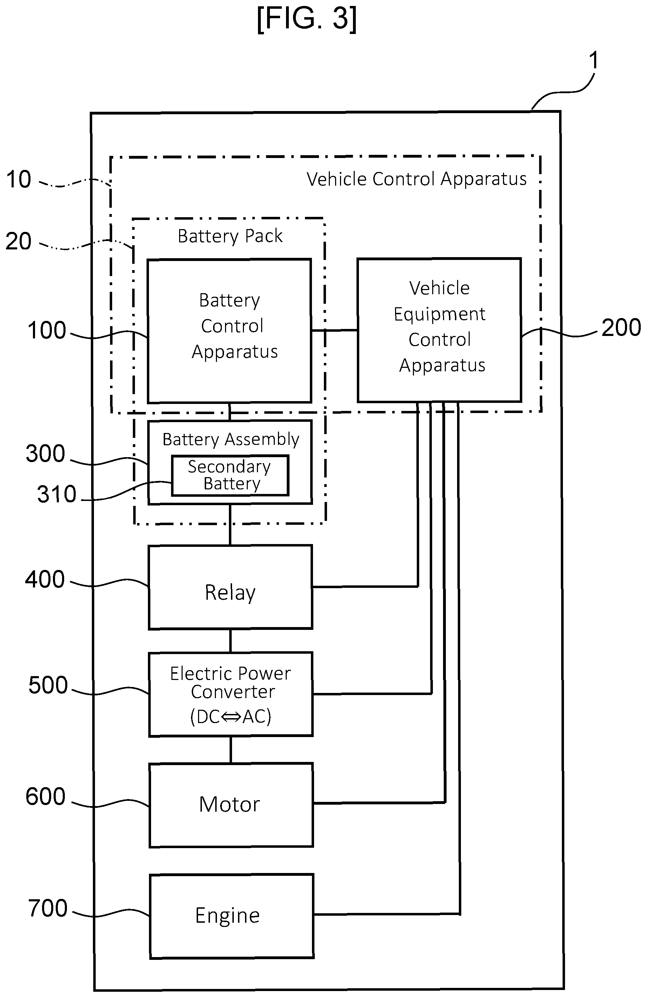

[Fig. 3] Fig. 3 is a block diagram depicting a vehicle 1 provided with a vehicle control apparatus 10 including a battery control apparatus 100 according to an embodiment.

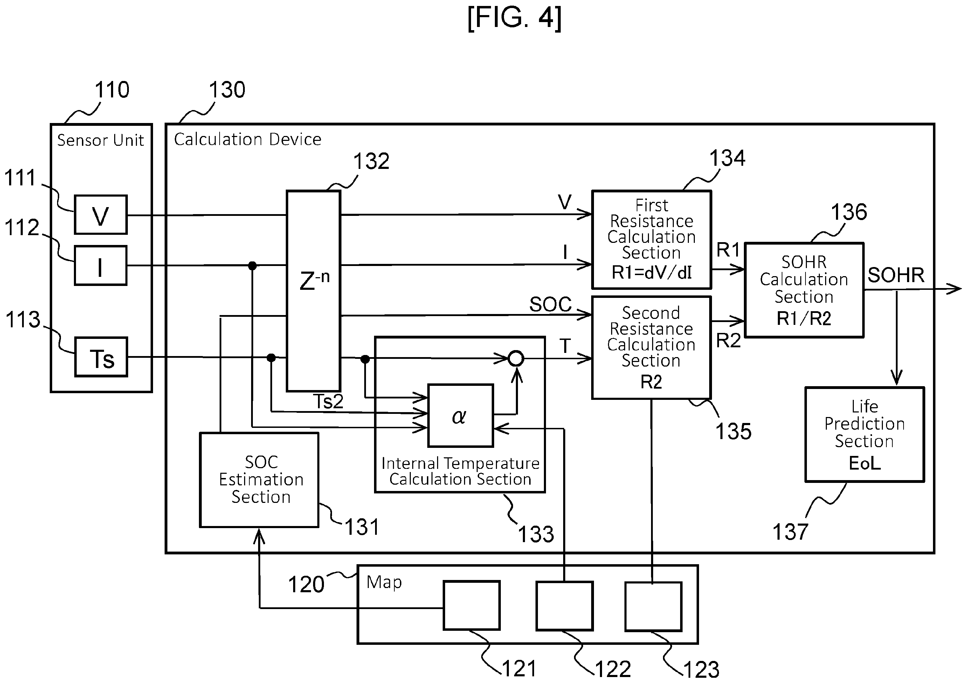

[Fig. 4] Fig. 4 is a block diagram depicting the battery control apparatus 100.

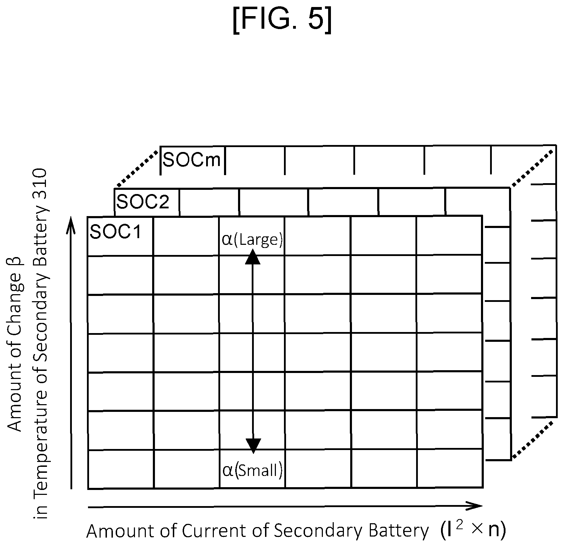

[Fig. 5] Fig. 5 depicts data that is included in a map 120 and indicates, for each of a plurality of SOCs of the secondary battery 310, a relation between a value obtained by squaring a current value in a predetermined energization time n of the secondary battery 310 and an amount of change β in the surface temperature Ts in the predetermined energization time n of the secondary battery 310.

### Mode for Carrying Out the Invention

### (Temperature Characteristics of Secondary Battery 310 Relating to Embodiment)

Temperature characteristics of a secondary battery 310 are described with reference to Figs. 1 and 2.

Fig. 1 is a graph depicting temperature characteristics of the secondary battery 310, and is a graph depicting, in an overlapping manner, an example of a relation between a predetermined energization time n and an internal temperature Ti of the secondary battery 310 and a relation between the predetermined energization time n and a surface temperature Ts of the secondary battery 310.

When the secondary battery 310 is energized, a electrode assembly included in the secondary battery 310 generates heat due to an electrochemical reaction. The electrode assembly is, for example, a wound body in which a positive electrode and a negative electrode are wound with a separator interposed therebetween. The electrode assembly may be a multilayer body in which a plurality of positive electrodes and a plurality of negative electrodes are laminated with a separator interposed therebetween. In the secondary battery 310, the electrode assembly is housed in an outer case. The outer case is, for example, a can and a lid. The outer case may be a laminate film. The heat generated in the electrode assembly moves from an interior of the secondary battery 310 toward a surface of the secondary battery 310. The surface of the secondary battery 310 is a surface of the lid or the can. The heat of the electrode assembly is dissipated from the interior of the secondary battery 310 toward the surface of the secondary battery 310.

Thus, when the secondary battery 310 is energized, a difference occurs between the temperature of the interior of the secondary battery 310 and the temperature of the exterior of the secondary battery 310 until the secondary battery 310 reaches a thermal equilibrium state. Therefore, as depicted in Fig. 1, an internal temperature curve L1 indicating the internal temperature Ti of the secondary battery 310 and a surface temperature curve L2 indicating the surface temperature Ts of the secondary battery 310 do not overlap each other in a region where the secondary battery 310 is not in a thermal equilibrium state. At any time point in the region where the secondary battery 310 is not in a thermal equilibrium state, the internal temperature Ti of the secondary battery 310 indicated by the internal temperature curve L1 is higher than the surface temperature Ts of the secondary battery 310 indicated by the surface temperature curve L2.

In the secondary battery 310, when a time point indicated in Fig. 1 is 0, the internal temperature curve L1 and the surface temperature curve L2 overlap each other. That is, when the time point is 0, the secondary battery 310 is in a thermal equilibrium state. When the time point is 0, the secondary battery 310 is not energized, and thus, the electrode assembly included in the secondary battery 310 does not generate heat. Therefore, when the time point is 0, the internal temperature Ti and the surface temperature Ts of the secondary battery 310 coincide with each other. That the internal temperature Ti and the surface temperature Ts of the secondary battery 310 coincide is premised on a situation in which a thermal influence of an ambient environment of the secondary battery 310 on the secondary battery 310 is sufficiently small.

In the secondary battery 310, the surface temperature Ts at any time point within a range from a first time-point c1 to a second time-point c2 indicated in Fig. 1 is defined as a first surface temperature Ts1. The first surface temperature Ts1 is, for example, the surface temperature Ts of the secondary battery 310 at the second time-point c2. The first surface temperature Ts1 may be one at the first time-point c1, or may be one at an intermediate time point between the first time-point c1 and the second time-point c2. A time from the first time-point c1 to the second time-point c2 is, for example, several tens of milliseconds. As described later, a first resistance value R1 of the secondary battery 310 is calculated by a battery control apparatus 100 during the time from the first time-point c1 to the second time-point c2. At any time point within the range from the first time-point c1 to the second time-point c2, the internal temperature Ti of the secondary battery 310 indicated by the internal temperature curve L1 is higher than the surface temperature Ts of the secondary battery 310 indicated by the surface temperature curve L2.

In the secondary battery 310, the surface temperature Ts at a third time-point c3 at which a predetermined time n has elapsed from the second time-point c2 indicated in Fig. 1 is defined as a second surface temperature Ts2. The predetermined time n is, for example, several seconds to several tens of seconds. As described later, an amount of current SI of the secondary battery 310 is calculated by the battery control apparatus 100 during the predetermined time n from a time point at which the first surface temperature Ts1 of the secondary battery 310 has been measured (any time point within the range from the first time-point c1 to the second time-point c2) to the third time-point c3. The amount of current SI of the secondary battery 310 is the integrated amount of current, and is a value obtained by squaring a current and multiplying the squared current by the predetermined time n (I² × n). At the third time-point c3, the internal temperature Ti of the secondary battery 310 indicated by the internal temperature curve L1 is higher than the surface temperature Ts of the secondary battery 310 indicated by the surface temperature curve L2.

In the secondary battery 310, a value obtained by subtracting the first surface temperature Ts1 from the second surface temperature Ts2 indicated in Fig. 1 is defined as an amount of change β. Because the secondary battery 310 is energized during the predetermined time n, the second surface temperature Ts2 is higher than the first surface temperature Ts1. That is, the amount of change β is the amount of increase in the surface temperature Ts of the secondary battery 310 during the predetermined time n, and corresponds to a surface temperature difference of the secondary battery 310. As described later, a correction value α of the surface temperature Ts of the secondary battery 310 is calculated by the battery control apparatus 100 on the basis of the amount of change β in the surface temperature Ts and the amount of current SI of the secondary battery 310.

In the secondary battery 310, at a fourth time-point c4 indicated in Fig. 1, the internal temperature curve L1 and the surface temperature curve L2 overlap each other. That is, at the fourth time-point c4, the secondary battery 310 is in a thermal equilibrium state.

Fig. 2 is a graph depicting temperature characteristics of the secondary battery 310, and is a graph depicting, in an overlapping manner, an example of a relation between a temperature T and resistance of the secondary battery 310 before deterioration and a relation between the temperature T and the resistance of the secondary battery 310 after deterioration.

Fig. 2 depicts, as a pre-deterioration resistance curve L3, a relation between the temperature T and a resistance value R of the secondary battery 310 before deterioration at any time point. The secondary battery 310 before deterioration corresponds, for example, to a new secondary battery 310. Fig. 2 depicts, as a post-deterioration resistance curve L4, a relation between the temperature T and the resistance value R of the secondary battery 310 before deterioration at a predetermined time point. The resistance of the secondary battery 310 increases due to deterioration. The resistance is, for example, internal resistance of the secondary battery 310. The internal resistance is, for example, DCR (Direct Current Resistance). Even when the secondary battery 310 is energized under the same conditions, the secondary battery 310 after deterioration has a larger resistance value R than that of the secondary battery 310 before deterioration. The temperature of the secondary battery 310 is premised on the temperature of the electrode assembly disposed inside the secondary battery 310. Thus, for calculation of the resistance value R of the secondary battery 310, it is preferable to employ not calculation based on the surface temperature Ts of the secondary battery 310 but calculation based on the internal temperature Ti estimated from the surface temperature Ts of the secondary battery 310.

An SOH of the secondary battery 310 depends on the temperature of the electrode assembly. The SOH (State of Health) is a deterioration rate of the secondary battery 310. The temperature of the electrode assembly is close not to the surface temperature Ts of the secondary battery 310 but to the internal temperature Ti of the secondary battery 310. As described later, in the embodiment, in order to improve calculation accuracy of the SOH of the secondary battery 310, the internal temperature Ti of the secondary battery 310 is accurately estimated on the basis of the measured surface temperature Ts of the secondary battery 310.

### (Configuration of Vehicle 1 Relating to Embodiment)

The battery control apparatus 100 and a vehicle control apparatus 10 of the embodiment are described on the basis of a configuration of a vehicle 1 provided with the vehicle control apparatus 10 including the battery control apparatus 100, with reference to Figs. 1 to 5.

Fig. 3 is a block diagram depicting the vehicle 1 provided with the vehicle control apparatus 10 including the battery control apparatus 100 according to the embodiment. Fig. 4 is a block diagram depicting the battery control apparatus 100. Fig. 5 depicts data that is included in a map 120 and indicates, for each of a plurality of SOCs of the secondary battery 310, a relation between a value obtained by squaring a current value in the predetermined energization time n of the secondary battery 310 and a temperature difference of the surface temperature Ts in the predetermined energization time n of the secondary battery 310.

### (Configuration of Vehicle 1)

The vehicle 1 is configured by, for example, a hybrid electric vehicle. The hybrid electric vehicle is, for example, an HEV (Hybrid Electric Vehicle) or a PHEV (Plug-in Hybrid Electric Vehicle). The hybrid electric vehicle includes a strong hybrid electric vehicle having an output voltage of, for example, several hundred volts and a mild hybrid electric vehicle having an output voltage of, for example, 48 V. The vehicle 1 may be configured by an EV (Electric Vehicle).

When the vehicle 1 is an HEV, the vehicle 1 is provided with a motor 600 that is electric equipment used to drive the vehicle 1 for traveling and an engine 700 that is an internal combustion engine. In the HEV, power generated by the motor 600 and the engine 700 is transmitted to tires. The motor 600 is actuated by electric power supplied from a battery pack 20. The HEV is provided with a generator for charging a battery assembly 300 of the battery pack 20. When the vehicle 1 is an EV, the vehicle 1 is not provided with the engine 700. In the EV, power generated by the motor 600 is transmitted to tires.

The vehicle 1 includes the battery control apparatus 100, a vehicle equipment control apparatus 200, the battery assembly 300, a relay 400, an electric power converter 500, the motor 600, and the engine 700. In the vehicle 1, a configuration including the battery control apparatus 100 and the vehicle equipment control apparatus 200 is referred to as the vehicle control apparatus 10. The vehicle control apparatus 10 includes the battery control apparatus 100. The vehicle control apparatus 10 controls the vehicle 1 having the secondary battery 310 and the electric equipment actuated by electric power of the secondary battery 310. In the vehicle 1, a configuration including the battery control apparatus 100 and the battery assembly 300 is referred to as the battery pack 20. A configuration of each of the components from the battery control apparatus 100 to the engine 700 in the vehicle 1 is described below.

### (Configuration of Battery Control Apparatus 100)

A configuration of the battery control apparatus 100 is described with reference to Figs. 1 to 5.

The battery control apparatus 100 is referred to as, for example, a battery management system (BMS). As depicted in Fig. 4, the battery control apparatus 100 includes a sensor unit 110, the map 120, and a calculation device 130. A configuration of each of the sensor unit 110, the map 120, and the calculation device 130 of the battery control apparatus 100 is described below.

### (Configuration of Sensor Unit 110)

The sensor unit 110 measures a voltage value V, a current value I, and the temperature T of the secondary battery 310 included in the battery assembly 300. As depicted in Fig. 4, the sensor unit 110 includes a voltage measurement section 111, a current measurement section 112, and a temperature measurement section 113. A configuration of each of the voltage measurement section 111, the current measurement section 112, and the temperature measurement section 113 of the sensor unit 110 is described below.

### (Configuration of Voltage Measurement Section 111)

The voltage measurement section 111 measures the voltage value V of the secondary battery 310. The voltage measurement section 111 is configured by, for example, a circuit obtained by combining a cell voltage detection terminal, an electric wire, a resistor, a capacitor, and the like. The voltage measurement section 111 measures the voltage value of the secondary battery 310 through a bus bar that electrically connects one secondary battery 310 and another secondary battery 310. The cell voltage detection terminal is attached to the bus bar. Thus, the potential of a negative electrode external terminal of the one secondary battery 310 is measured, and the potential of a positive electrode external terminal of the other secondary battery 310 is measured. The voltage measurement section 111 measures the voltage value of the secondary battery 310 on the basis of a difference between the potential of the positive electrode external terminal of the secondary battery 310 and the potential of the negative electrode external terminal of the secondary battery 310. The voltage value V of the secondary battery 310 corresponds to an open-circuit voltage (OCV) of the secondary battery 310.

### (Configuration of Current Measurement Section 112)

The current measurement section 112 measures the current value I of the secondary battery 310. The current measurement section 112 is configured to be used together with the circuit of the voltage measurement section 111. The voltage measurement section 111 calculates the current value I of the secondary battery 310 on the basis of a value of a current flowing through the resistor of the voltage measurement section 111.

### (Configuration of Temperature Measurement Section 113)

The temperature measurement section 113 measures the surface temperature Ts of the secondary battery 310. The temperature measurement section 113 is attached to a surface of the secondary battery 310. The surface of the secondary battery 310 is, for example, a surface of the lid of the secondary battery 310, and is a surface of a portion on which a rupture valve or the like is not formed. The temperature measurement section 113 is in contact with the surface of the secondary battery 310 while being pressed against the surface by a support member. The temperature measurement section 113 may be bonded to the surface of the secondary battery 310 by an adhesive. The temperature measurement section 113 is attached to all of the plurality of secondary batteries 310. The temperature measurement section 113 may be attached to some of the secondary batteries 310. When the temperature measurement section 113 is attached to some of the plurality of secondary batteries 310, for example, an average value of the surface temperatures Ts of some of the secondary batteries 310 is used as the surface temperature Ts of the secondary battery 310.

### (Configuration of Map 120)

A configuration of the map 120 is described with reference to Fig. 5 and other figures.

Fig. 5 depicts data included in the map 120. The data indicates, for each of the plurality of SOCs of the secondary battery 310, the relation between the value obtained by squaring the current value in the predetermined energization time n of the secondary battery 310 and the amount of change β in the surface temperature Ts in the predetermined energization time n of the secondary battery 310.

The map 120 includes an OCV-SOC correlation table 121, a temperature correction table 122 depicted in Fig. 5, and a resistance value correlation table 123.

The OCV-SOC correlation table 121 is referenced by an SOC estimation section 131 of the calculation device 130 to be described later. The OCV-SOC correlation table 121 is a table indicating a relation between the OCV and the SOC. The OCV is the open-circuit voltage of the secondary battery 310. The SOC (States of Charge) is a state of charge of the secondary battery 310. For example, the secondary battery 310 such as a lithium-ion secondary battery has a correlation between the OCV and the SOC. In such a secondary battery 310, a predetermined SOC corresponding to a predetermined OCV is present. That is, in the secondary battery 310, a relation between the OCV and the SOC represented by a curve is present. Thus, for the secondary battery 310, by calculating the OCV, the SOC corresponding thereto can be estimated.

The temperature correction table 122 is referenced by an internal temperature calculation section 133 of the calculation device 130 to be described later. The temperature correction table 122 indicates, for each of the plurality of SOCs of the secondary battery 310, the relation between the value obtained by squaring the current value in the predetermined energization time n of the secondary battery 310 (I² × n) and the amount of change β in the surface temperature Ts in the predetermined energization time n of the secondary battery 310. The temperature correction table 122 cancels influences of discharging and charging of the secondary battery 310 by using the value obtained by squaring the current value I of the secondary battery 310. The temperature correction table 122 indicates the correction value α of the surface temperature Ts of the secondary battery 310 at the second time-point c2 corresponding to the amount of change β in the surface temperature Ts of the secondary battery 310. By adding the correction value α to the surface temperature Ts of the secondary battery 310 at the second time-point c2, the internal temperature Ti of the secondary battery 310 at the second time-point c2 is estimated.

The resistance value correlation table 123 is referenced by a second resistance calculation section 135 of the calculation device 130 to be described later. The resistance value correlation table 123 is a table indicating a relation between the SOC of the secondary battery 310 and a resistance value of the secondary battery 310 before deterioration corresponding to the internal temperature Ti of the secondary battery 310 (second resistance value R2). The resistance value correlation table 123 indicates a relation between the internal resistance and the SOC of the secondary battery 310 before deterioration, that is, between the internal resistance and the SOC of the secondary battery 310 when the secondary battery 310 is new.

### (Configuration of Calculation Device 130)

The calculation device 130 calculates the SOH of the secondary battery 310 on the basis of the amount of change in each of the voltage value V, the current value I, and the surface temperature Ts of the secondary battery 310.

The calculation device 130 includes information processing devices such as a CPU (Central Processing Unit), an ECU (Electronic Control Unit), an MPU (Micro Processing Unit), and a DSP (Digital Signal Processor). The calculation device 130 includes storage devices (memories) such as a ROM (Read Only Memory) and a RAM (Random Access Memory). The information processing devices included in the calculation device 130 execute calculations on the basis of programs and data stored in a recording device.

As depicted in Fig. 4, the calculation device 130 includes the SOC estimation section 131, a delay block 132, the internal temperature calculation section 133, a first resistance calculation section 134, the second resistance calculation section 135, an SOHR calculation section 136, and a life prediction section 137. A configuration of each of the sections from the SOC estimation section 131 to the life prediction section 137 in the calculation device 130 is described below.

### (Configuration of SOC Estimation Section 131 of Calculation Device 130)

The SOC estimation section 131 of the calculation device 130 estimates the SOC of the secondary battery 310 on the basis of the voltage value V of the secondary battery 310 measured by the voltage measurement section 111 of the sensor unit 110 and the OCV-SOC correlation table 121 of the map 120. When the voltage value V of the secondary battery 310 measured by the voltage measurement section 111 is defined as a predetermined voltage value, the SOC estimation section 131 first extracts the OCV equivalent to the predetermined voltage value from the OCV-SOC correlation table 121, and then derives the SOC in the OCV-SOC correlation table 121 corresponding to the extracted OCV. The SOC estimation section 131 estimates the SOC derived from the OCV-SOC correlation table 121 as the SOC of the secondary battery 310.

### (Configuration of Delay Block 132 of Calculation Device 130)

The delay block 132 of the calculation device 130 inputs, to the internal temperature calculation section 133, the second surface temperature Ts2 of the secondary battery 310 measured by the temperature measurement section 113 at the third time-point c3 indicated in Fig. 1.

### (Configuration of Internal Temperature Calculation Section 133 of Calculation Device 130)

The internal temperature calculation section 133 of the calculation device 130 calculates the internal temperature Ti of the secondary battery 310 at the second time-point c2. The first surface temperature Ts1 indicated in Fig. 1 is input from the temperature measurement section 113 to the internal temperature calculation section 133. The first surface temperature Ts1 is, for example, the surface temperature Ts of the secondary battery 310 at the second time-point c2. The second surface temperature Ts2 indicated in Fig. 1 is input from the temperature measurement section 113 to the internal temperature calculation section 133 through the delay block 132. The second surface temperature Ts2 is the surface temperature Ts of the secondary battery 310 at the third time-point c3. The internal temperature calculation section 133 calculates the amount of change β in the surface temperature Ts of the secondary battery 310 on the basis of the first surface temperature Ts1 and the second surface temperature Ts2. The amount of change β is a value obtained by subtracting the first surface temperature Ts1 from the second surface temperature Ts2.

The current value I is input from the current measurement section 112 to the internal temperature calculation section 133. The internal temperature calculation section 133 calculates the value obtained by squaring the current value I in the energization time n of the secondary battery 310 (I² × n). That is, the internal temperature calculation section 133 calculates the amount of current SI (I² × n) of the secondary battery 310 from the time point at which the first surface temperature Ts1 of the secondary battery 310 has been measured to the third time-point c3 at which the second surface temperature Ts2 of the secondary battery 310 has been measured. The internal temperature calculation section 133 calculates the correction value α of the first surface temperature Ts1 of the secondary battery 310 on the basis of the amount of change β in the surface temperature Ts and the amount of current SI (I² × n) of the secondary battery 310. As depicted in Fig. 1, a value obtained by adding the correction value α to the first surface temperature Ts1 at the second time-point c2 corresponds to the internal temperature Ti of the secondary battery 310 at the second time-point c2. It is also possible to employ a configuration in which, without using the correction value α, a predetermined coefficient is used for multiplication, division, or addition with respect to the surface temperature Ts of the secondary battery 310 on the basis of the amount of change β in the surface temperature Ts of the secondary battery 310.

### (Configuration of First Resistance Calculation Section 134 of Calculation Device 130)

The first resistance calculation section 134 of the calculation device 130 calculates the first resistance value R1 of the secondary battery 310 on the basis of the voltage value V and the current value I of the secondary battery 310 input from the sensor unit 110. The first resistance value R1 corresponds to internal resistance of the secondary battery 310 at the time point of the calculation. The internal resistance of the secondary battery 310 corresponds, for example, to DCR (Direct Current Resistance), which is direct-current resistance of the secondary battery 310.

The first resistance calculation section 134 calculates the first resistance value R1 of the secondary battery 310 on the basis of an amount of change dV in the voltage value V of the secondary battery 310 during a time from the first time-point c1 to the second time-point c2 depicted in Fig. 1 and an amount of change dI in the current value I during the time from the first time-point c1 to the second time-point c2. The amount of change dV in the voltage value V of the secondary battery 310 is a value obtained by subtracting the voltage value V of the secondary battery 310 at the first time-point c1 from the voltage value V of the secondary battery 310 at the second time-point c2. The amount of change dI in the current value I of the secondary battery 310 is a value obtained by subtracting the current value I of the secondary battery 310 at the first time-point c1 from the current value I of the secondary battery 310 at the second time-point c2. The time from the first time-point c1 to the second time-point c2 is set to, for example, several tens of milliseconds. The time from the first time-point c1 to the second time-point c2 may be set to several milliseconds to several hundreds of milliseconds, or may be set to one second or longer.

### (Configuration of Second Resistance Calculation Section 135 of Calculation Device 130)

The second resistance calculation section 135 of the calculation device 130 calculates the resistance value of the secondary battery 310 before deterioration (second resistance value R2). The second resistance value R2 corresponds to internal resistance of the secondary battery 310 when the secondary battery 310 is new. The second resistance calculation section 135 of the calculation device 130 calculates the second resistance value R2 of the secondary battery 310 on the basis of the SOC of the secondary battery 310 input from the SOC estimation section 131, the surface temperature Ts of the secondary battery 310 that is input from the internal temperature calculation section 133 and results from the correction by the correction value α (the surface temperature Ts corresponding to the internal temperature Ti), and the resistance value correlation table 123. The resistance value correlation table 123 indicates a relation between the SOC of the secondary battery 310, the surface temperature Ts of the secondary battery 310 (corrected to the internal temperature Ti by the correction value α), and the resistance value of the secondary battery 310 before deterioration (second resistance value R2). That is, the second resistance calculation section 135 estimates the second resistance value R2 of the secondary battery 310 that reflects a difference between the internal temperature Ti and the surface temperature Ts of the secondary battery 310, on the basis of the estimated internal temperature Ti of the secondary battery 310, while referring to a relation between the surface temperature Ts, the internal temperature Ti, and the resistance value R of the secondary battery 310.

### (Configuration of SOHR Calculation Section 136 of Calculation Device 130)

The SOHR calculation section 136 of the calculation device 130 calculates the deterioration rate of the secondary battery 310 on the basis of the amount of change in each of the voltage value V, the current value I, and the surface temperature Ts of the secondary battery 310. Specifically, the SOHR calculation section 136 calculates the deterioration rate of the secondary battery 310 on the basis of the first resistance value R1 of the secondary battery 310 calculated by the first resistance calculation section 134 and the second resistance value R2 of the secondary battery 310 calculated by the second resistance calculation section 135. As described above, when calculating the first resistance value R1, the first resistance calculation section 134 refers to the amounts of change in the voltage value V and the current value I of the secondary battery 310. Further, as described above, when calculating the second resistance value R2, the second resistance calculation section 135 refers to the amount of change β in the surface temperature Ts of the secondary battery 310.

The SOHR calculation section 136 calculates the deterioration rate of the secondary battery 310 by, for example, dividing the first resistance value R1 by the second resistance value R2. The deterioration rate of the secondary battery 310 corresponds to the SOH. The SOH is represented by, for example, a deterioration rate of resistance of the secondary battery 310. That is, the SOH is represented by, for example, an SOHR (State of Health based on Resistance). The resistance of the secondary battery 310 is the internal resistance of the secondary battery 310. Therefore, the SOHR calculation section 136 calculates the SOH as a resistance increase rate, that is, the SOHR, of the secondary battery 310 on the basis of the first resistance value R1 of the secondary battery 310 and the second resistance value R2 of the secondary battery 310.

The SOHR calculation section 136 of the calculation device 130 may be configured to calculate an SOHC instead of calculating the SOH. The SOHC (State of Health based on Capacity) is a deterioration rate of capacity of the secondary battery 310. In a case of such a configuration, configurations of the first resistance calculation section 134 and the second resistance calculation section 135 are each changed to a configuration for calculating the capacity of the secondary battery 310.

### (Configuration of Life Prediction Section 137 of Calculation Device 130)

The life prediction section 137 of the calculation device 130 predicts a life of the secondary battery 310 on the basis of the SOH. The life prediction section 137 predicts the life of the secondary battery 310 on the basis of the SOHR of the secondary battery 310 calculated by the SOHR calculation section 136. The life prediction section 137 predicts the life of the secondary battery 310 on the basis of, for example, the amount of change in the SOHR of the secondary battery 310 calculated by the SOHR calculation section 136. Further, the life prediction section 137 predicts the life of the secondary battery 310 on the basis of the SOHR of the secondary battery 310 calculated by the SOHR calculation section 136 and a usage history of the secondary battery 310. Moreover, on the premise of the battery assembly 300 including a plurality of secondary batteries 310, the life prediction section 137 predicts a life of the battery assembly 300 on the basis of the SOHR of each secondary battery 310 and a usage history of the battery assembly 300.

### (Configuration of Vehicle Equipment Control Apparatus 200)

A configuration of the vehicle equipment control apparatus 200 is described with reference to Fig. 3. The vehicle equipment control apparatus 200 controls drive equipment of the vehicle 1. The vehicle equipment control apparatus 200 includes information processing devices such as a CPU, an ECU, an MPU, and a DSP. The vehicle equipment control apparatus 200 includes storage devices such as a ROM and a RAM. The information processing devices included in the vehicle equipment control apparatus 200 execute control on the basis of programs and data stored in a recording device. The information processing devices and the recording device of the vehicle equipment control apparatus 200 may be used also as the information processing devices and the recording device of the battery control apparatus 100. The drive equipment of the vehicle 1 includes the relay 400, the electric power converter 500, the motor 600, and the engine 700. The vehicle equipment control apparatus 200 refers to information on electric power of the battery assembly 300 output from the battery control apparatus 100.

### (Configuration of Battery Assembly 300)

A configuration of the battery assembly 300 is described with reference to Fig. 3. The battery assembly 300 includes the plurality of secondary batteries 310. The plurality of secondary batteries 310 are connected in series, connected in parallel, or connected in series and in parallel by bus bars. The secondary batteries 310 are, for example, lithium-ion batteries. Electric power of the battery assembly 300 is supplied to the motor 600 through the relay 400 and the electric power converter 500. The secondary batteries 310 may be configured by devices having an electric power storage function, such as a nickel-metal hydride battery, an all-solid-state battery, a lead battery, and an electric double-layer capacitor. The battery assembly 300 may be configured by one secondary battery 310.

### (Configuration of Relay 400)

A configuration of the relay 400 is described with reference to Fig. 3. The relay 400 is connected to and between the battery assembly 300 and the electric power converter 500. The relay 400 causes energization from the battery assembly 300 to the motor 600 through the electric power converter 500. Further, the relay 400 interrupts the energization from the battery assembly 300 to the motor 600 through the electric power converter 500.

### (Configuration of Electric Power Converter 500)

A configuration of the electric power converter 500 is described with reference to Fig. 3. The electric power converter 500 is connected to and between the relay 400 and the motor 600. The electric power converter 500 transforms a voltage of electric power of the battery assembly 300 at least while converting the electric power from direct current (DC) to alternating current (AC). The electric power converter 500 includes an inverter circuit and a converter circuit.

### (Configuration of Motor 600)

A configuration of the motor 600 is described with reference to Fig. 3. The motor 600 executes motoring operation of generating a driving force and regenerative operation of recovering energy according to a traveling state of the vehicle 1. In the motoring operation of the motor 600, the electric power converter 500 converts electric power output from the battery assembly 300 from direct current to alternating current and transforms a voltage, to supply the electric power to the motor 600. As a result, power is generated by the motor 600, and the vehicle 1 travels. In the regenerative operation of the motor 600, the electric power converter 500 converts electric power generated by the motor 600 from alternating current to direct current and transforms a voltage, to supply the electric power to the battery assembly 300. As a result, the battery assembly 300 is charged.

### (Configuration of Engine 700)

A configuration of the engine 700 is described with reference to Fig. 3. The engine 700 is an internal combustion engine. The engine 700 drives the vehicle 1. The engine 700 is used as, for example, a drive source for tires of the vehicle 1. When the vehicle 1 is an EV, the engine 700 is not used.

### (Effects of Embodiment)

Effects of the battery control apparatus 100 and the vehicle control apparatus 10 of the embodiment are described with reference to Figs. 1 to 5.

(1) The battery control apparatus 100 includes the map and the calculation device 130. The map includes the data indicating the relation between the surface temperature Ts, the internal temperature Ti, and the resistance value R of the secondary battery 310. The calculation device 130 calculates the SOH of the secondary battery 310 on the basis of the amount of change in each of the voltage value, the current value, and the surface temperature Ts of the secondary battery 310. The calculation device 130 calculates the first resistance value R1 of the secondary battery 310 on the basis of the amount of change dV in the voltage value V of the secondary battery 310 during the time from the first time-point c1 to the second time-point c2 and the amount of change dI in the current value I during the time from the first time-point c1 to the second time-point c2. The calculation device 130 calculates the amount of change β in the surface temperature Ts of the secondary battery 310 on the basis of the first surface temperature Ts1 of the secondary battery 310 within the range from the first time-point c1 to the second time-point c2 and the second surface temperature Ts2 of the secondary battery 310 at the third time-point c3 at which the predetermined time n has elapsed from the second time-point c2. The calculation device 130 calculates the amount of current SI of the secondary battery 310 from the time point at which the first surface temperature Ts1 of the secondary battery 310 has been measured to the third time-point c3 at which the second surface temperature Ts2 of the secondary battery 310 has been measured. The calculation device 130 estimates the internal temperature Ti of the secondary battery 310 on the basis of the amount of change β in the surface temperature and the amount of current SI of the secondary battery 310. The calculation device 130 estimates the second resistance value R2 of the secondary battery 310 that reflects the difference between the internal temperature Ti and the surface temperature Ts of the secondary battery 310, on the basis of the estimated internal temperature Ti of the secondary battery 310, while referring to the relation between the surface temperature Ts, the internal temperature Ti, and the resistance value R of the secondary battery 310 stored in the map. The calculation device 130 calculates the SOH of the secondary battery 310 on the basis of the first resistance value R1 of the secondary battery 310 and the second resistance value R2 of the secondary battery 310.

With the battery control apparatus 100 having such a configuration, the resistance value of the secondary battery 310 is estimated with the reflection of the difference between the internal temperature Ti and the surface temperature Ts of the secondary battery 310. The calculation device 130 calculates the SOH of the secondary battery 310 on the basis of the resistance value of the secondary battery 310. Accordingly, the battery control apparatus 100 can improve calculation accuracy of the SOH of the secondary battery 310. That is, the battery control apparatus 100 can improve reliability of the secondary battery 310.

(2) The calculation device 130 calculates the correction value α of the surface temperature Ts of the secondary battery 310 on the basis of the amount of change β in the surface temperature Ts and the amount of current SI of the secondary battery 310. The calculation device 130 estimates the internal temperature Ti of the secondary battery 310 corresponding to the surface temperature Ts of the secondary battery 310 that reflects the correction value α.

With the battery control apparatus 100 having such a configuration, the internal temperature Ti of the secondary battery 310 can be estimated by a relatively highly versatile and simple method using the correction value α. Accordingly, the battery control apparatus 100 can improve the calculation accuracy of the SOH of the secondary battery 310.

(3) The calculation device 130 calculates the SOH as the resistance increase rate (SOHR) of the secondary battery 310 on the basis of the first resistance value R1 and the second resistance value R2.

The battery control apparatus 100 having such a configuration can be applied to calculation of the SOHR having relatively high versatility in improving the calculation accuracy of the SOH of the secondary battery 310.

(4) The data included in the map indicates at least a relation between the SOC in addition to the surface temperature Ts, the internal temperature Ti, and the resistance value R of the secondary battery 310.

With the battery control apparatus 100 having such a configuration, when a correlation exists between the resistance value R and the SOC of the secondary battery 310, the calculation accuracy of the SOH of the secondary battery 310 can further be improved by also taking the value of the SOC of the secondary battery 310 into consideration. Similarly, with the battery control apparatus 100 having such a configuration, when a correlation exists between the internal temperature Ti, the resistance value R, and the SOC of the secondary battery 310, the calculation accuracy of the SOH of the secondary battery 310 can further be improved by also taking the value of the SOC of the secondary battery 310 into consideration.

(5) The calculation device 130 predicts the life of the secondary battery 310 on the basis of the SOH.

With the battery control apparatus 100 having such a configuration, accuracy of prediction of the life of the secondary battery 310 can be improved by improvement in the calculation accuracy of the SOH of the secondary battery 310. Therefore, the battery control apparatus 100 can make the secondary battery 310 supply electric power to the electric equipment such as the motor 600 until immediately before the secondary battery 310 reaches the end of the life. That is, the battery control apparatus 100 allows the secondary battery 310 to be used up. Further, the battery control apparatus 100 can suppress supplying electric power from the secondary battery 310 to the electric equipment such as the motor 600 after the secondary battery 310 has reached the end of the life.

(6) The battery control apparatus 100 further has the voltage measurement section 111 that measures the voltage value V of the secondary battery 310, the current measurement section 112 that measures the current value I of the secondary battery 310, and the temperature measurement section 113 that measures the surface temperature Ts of the secondary battery 310.

With the battery control apparatus 100 having such a configuration, the SOH of the secondary battery 310 can be calculated even in a case where the voltage measurement section 111, the current measurement section 112, and the temperature measurement section 113 are not provided on the side of the secondary battery 310. The case where the voltage measurement section 111, the current measurement section 112, and the temperature measurement section 113 are not provided on the side of the secondary battery 310 also includes a case where the voltage measurement section 111, the current measurement section 112, and the temperature measurement section 113 are not provided on the side of the battery assembly 300.

(7) The vehicle control apparatus 10 includes the battery control apparatus 100. The vehicle control apparatus 10 controls the vehicle 1 having the secondary battery 310 and the motor 600 (electric equipment) actuated by electric power of the secondary battery 310.

With the vehicle control apparatus 10 having such a configuration, the motor 600 that the vehicle 1 has can be actuated more effectively by improving the calculation accuracy of the SOH of the secondary battery 310. The electric equipment is not limited to the motor 600. The electric equipment may be, for example, an air conditioner that the vehicle 1 has.

(8) The vehicle 1 has the engine 700 (internal combustion engine) that drives the vehicle 1.

With the vehicle control apparatus 10 having such a configuration, the engine 700 can appropriately be actuated by improving the calculation accuracy of the SOH of the secondary battery 310. That is, it is preferable that the vehicle control apparatus 10 be applied to, for example, an HEV. That the engine 700 is appropriately actuated means, for example, suppressing actuation of the engine 700 as much as possible when it is desired to suppress actuation of the engine 700 in actuating the vehicle 1.

### (Other Embodiments)

Although the embodiment of the present invention has been described above, the above-described embodiment merely depicts some of application examples of the present invention, and is not intended to limit the technical scope of the present invention to specific configurations of the above-described embodiment.

For example, the battery control apparatus 100 of the present invention is not limited to a configuration that controls the secondary battery 310 used in the vehicle 1. The battery control apparatus 100 of the present invention may be configured to control the secondary battery 310 used in machine tools, aircraft, ships, and the like.

### Description of Reference Characters

- 1:: Vehicle
- 10:: Vehicle control apparatus
- 20:: Battery pack
- 100:: Battery control apparatus
- 110:: Sensor unit
- 111:: Voltage measurement section
- 112:: Current measurement section
- 113:: Temperature measurement section
- 120:: Map
- 121:: OCV-SOC correlation table
- 122:: Temperature correction table
- 123:: Resistance value correlation table
- 130:: Calculation device
- 131:: SOC estimation section
- 132:: Delay block
- 133:: Internal temperature calculation section
- 134:: First resistance calculation section
- 135:: Second resistance calculation section
- 136:: SOHR calculation section
- 137:: Life prediction section
- 200:: Vehicle equipment control apparatus
- 300:: Battery assembly
- 310:: Secondary battery
- 400:: Relay
- 500:: Electric power converter
- 600:: Motor (electric equipment)
- 700:: Engine (internal combustion engine)
- Ti:: Internal temperature
- Ts:: Surface temperature
- Ts1:: First surface temperature
- Ts2:: Second surface temperature
- c1:: First time-point
- c2:: Second time-point
- c3:: Third time-point
- c4:: Fourth time-point
- L1:: Internal temperature curve
- L2:: Surface temperature curve
- L3:: Pre-deterioration resistance curve
- L4:: Post-deterioration resistance curve
- R1:: First resistance value
- R2:: Second resistance value
- SI:: Amount of current
- α:: Correction value
- β:: Amount of change

## Claims

1. A battery control apparatus comprising:
a map that includes data indicating a relation between a surface temperature, an internal temperature, and a resistance value of a secondary battery; and
a calculation device configured to calculate a deterioration rate of the secondary battery based on an amount of change in each of a voltage value, a current value, and the surface temperature of the secondary battery, wherein
the calculation device is configured to
calculate a first resistance value of the secondary battery based on an amount of change in the voltage value during a time from a first time-point to a second time-point and an amount of change in the current value during the time from the first time-point to the second time-point,
calculate an amount of change in the surface temperature based on a first surface temperature within a range from the first time-point to the second time-point and a second surface temperature at a third time-point at which a predetermined time has elapsed from the second time-point,
calculate an amount of current of the secondary battery from a time point at which the first surface temperature has been measured to the third time-point at which the second surface temperature has been measured,
estimate the internal temperature of the secondary battery based on the amount of change in the surface temperature and the amount of current,
estimate a second resistance value that reflects a difference between the internal temperature and the surface temperature of the secondary battery, based on the estimated internal temperature, while referring to the relation between the surface temperature, the internal temperature, and the resistance value stored in the map, and
calculate the deterioration rate based on the first resistance value and the second resistance value.

2. The battery control apparatus according to claim 1, wherein
the calculation device is configured to
calculate a correction value of the surface temperature based on the amount of change in the surface temperature and the amount of current, and
estimate the internal temperature corresponding to the surface temperature that reflects the correction value.

3. The battery control apparatus according to claim 1, wherein
the calculation device is configured to
calculate the deterioration rate as a resistance increase rate of the secondary battery based on the first resistance value and the second resistance value.

4. The battery control apparatus according to claim 1, wherein
the data indicates a relation between the internal temperature, the resistance value, and a state of charge of the secondary battery.

5. The battery control apparatus according to claim 1, wherein
the calculation device is configured to predict a life of the secondary battery based on the deterioration rate.

6. The battery control apparatus according to claim 1, further comprising:
a voltage measurement section that measures the voltage value of the secondary battery;
a current measurement section that measures the current value of the secondary battery; and
a temperature measurement section that measures the surface temperature of the secondary battery.

7. A vehicle control apparatus comprising:
the battery control apparatus according to claim 1, wherein
the vehicle control apparatus is configured to control a vehicle having the secondary battery and electric equipment actuated by electric power of the secondary battery.

8. The vehicle control apparatus according to claim 7, wherein
the vehicle has an internal combustion engine that drives the vehicle.
